# EUROPÄISCHE PATENTSCHRIFT

(11) **EP 0 401 622 B1**
(45) Veröffentlichungstag und Bekanntmachung des Hinweises auf die Patenterteilung: **23.08.1995**
(21) Anmeldenummer: 90110019.8
(22) Anmeldetag: 26.05.1990
(51) Int. Cl.: H01J 37/34, C23C 14/34

(54) **Verfahren zum Kühlen von Targets sowie Kühleinrichtung für Targets**
Target cooling procedure and device for cooling targets
Procédé de refroidissement de cible ainsi que dispositifs de refroidissement de cibles

(30) Priorität: 05.06.1989 CH 2107/89
(43) Veröffentlichungstag der Anmeldung: 12.12.1990
(73) Patentinhaber: BALZERS AKTIENGESELLSCHAFT, 9496 Balzers (LI)
(72) Erfinder: Wegmann, Urs, CH-9479 Oberschan (CH); Haag, Walter, CH-9472 Grabs (CH)
(74) Vertreter: Troesch, Jacques J., Dr. sc. nat.

(56) Entgegenhaltungen:
- DE-C- 3 630 737
- US-A- 4 407 708
- JOURNAL OF VACUUM SCIENCE AND TECHNOLOGY: PART A. vol. A, no. 3, September 1984, NEW YORK US Seiten 1391 - 1393; M.R. Lake et al.: "Cathode cooling apparatus for a planar magnetron sputtering system"
- PATENT ABSTRACTS OF JAPAN vol. 9, no. 21 (C-263)(1744) 29 Januar 1985,& JP-A-59 170269

## Beschreibung

Die vorliegende Erfindung betrifft ein Verfahren zum Kühlen von Targets in Zerstäubungsquellen sowie eine Kühleinrichtung für Targets von Zerstäubungsquellen mit einem Target und mit von Kühlmittel durchflossener Kanalanordnung.

Beim Zerstäuben von Targets mit Zerstäubungsquellen, insbesondere bei Verwendung von sogenannten Hochratequellen, wie Magnetronzerstäubungsquellen, tritt das Problem auf, rechtzeitig zu erkennen, wann das Target verbraucht ist. Wird der Plasmaprozess nicht rechtzeitig unterbrochen, erodiert das Target durch, wobei eine Oeffnung entsteht, welche die rückseitigen Konstruktionselemente der Magnetronquelle gegenüber dem Plasma exponiert. Dies führt zu einem Mitzerstäuben von Konstruktionsmaterial, was in der Regel eine unzulässige Verunreinigung der zu erzeugenden hochreinen Schicht bedeutet. Noch schlimmere Folgen hätte das Durchbrechen auf die Kühleinrichtung, wodurch Kühlmedium in die Prozesskammer eintritt. Dies führt zu einer Zerstörung der Substrate sowie zu einem Totalausfall der Anlage unter hohen Kostenfolgen.

Es ist bekannt, dass bei Kathoden-Zerstäubungsanlagen die sogenannten Targets intensiv gekühlt werden müssen, um optimale Betriebsleistungen beim Zerstäuben des Targets erreichen zu können. Diese Kühlung kann direkt oder indirekt sein, indem bei jener das Target mit der kühlenden Kühlflüssigkeit, z.B. Wasser, in direkte Berührung gebracht wird oder bei dieser, indirekt, über eine Zwischenwand. Die vom Target abzuführende Wärme kann mithin entweder durch Wärmeübergang direkt an das Kühlmedium bei direkter Kühlung oder durch Wärmeleitung durch eine Wand bei indirekter Kühlung abgeführt werden.

Aus der DE-C-36 30 737 ist eine indirekte Targetkühlung bekannt. Hinter einer Platte, auf der das Target aufliegt, sind in ovaler Bahn Magnete angeordnet, dazwischen, seitlich und zentral, sind in einer Kühlplatte Kühlkanäle angeordnet; das darin enthaltene Kühlmedium tritt direkt mit der Rückseite der das Target abstützenden Platte in Kontakt. Die Erosionstiefe im Target wird überwacht.

Es ist ferner bekannt, dass bei direkter Kühlung die Targetmontage wegen der Gefahr von Undichtheiten besonders sorgfältig vorzunehmen ist.

Bei der indirekten Kühlung wird das Kühlmedium durch Kühlkanäle, die sich im Innern einer Rückplatte befinden, strömen. Diese Kühlart ist problemlos bezüglich Undichtheiten, jedoch wesentlich weniger wirkungsvoll bezüglich Kühleffekt als die direkte Kühlung.

Um die Nachteile der direkten Kühlung einerseits und diejenigen der indirekten andererseits zu umgehen, ist auch bekannt geworden, die Rückplatte, wie bei der direkten Kühlung, mit gegen die Targetrückseite hin offenen Kanälen auszubilden und diese Kanäle durch eine flexible, vorzugsweise aus Metall bestehende Folie nach aussen flüssigkeitsdicht abzuschliessen. Im Betrieb bewirkt dann der Flüssigkeitsdruck in den Kühlkanälen, dass diese flexible Metallfolie gegen die Targetrückwand gepresst wird und auf diese Weise die Wärmeübertragung durch Steigerung der Wärmeleitung wesentlich verbessert wird.

J. Vac. Sci. Technol. A2(3), July-Sept. 1984, "Cathode cooling apparatus for a planar magnetron sputtering system" von M.R. Lake und G.L. Harding sowie "Planar Magnetron Zerstäubungsquellen" von Dipl.-Ing. Urs Wegmann, Balzers Fachbericht, BB 800 014 DD 8102.

In diesem Balzers-Bericht ist dargestellt, wie die durch die Erosion entstehenden sogenannten Abtragsprofile bei Targets aussehen. Es entsteht im Zentrum der Abtragungszone des Targets eine V-förmige Vertiefung. Das Targetmaterial wird m.a.W. nicht gleichmässig abgetragen. Zwecks Ausnützung des teuren Targetmaterials wird aber bis an die Grenze des Möglichen gegangen, ohne aber einen Durchbruch des Targets infolge der Erosion gegen die Rückplatte hin zu riskieren.

Die vorliegende Erfindung geht von einem Targetkühlverfahren aus bzw. einer entsprechenden Kühleinrichtung, bei dem bzw. bei der das Kühlmedium die Targetrückseite direkt oder über eine Folie kontaktiert.

Davon ausgehend, stellt sich die Erfindung die Aufgabe, den Nachteil bezüglich Durcherosionsgefahr zu beheben und damit die gefährdungsfreie Ausnützbarkeit des Targets zu erhöhen.

Dies wird durch das Verfahren nach dem kennzeichnenden Teil von Anspruch 1 bzw. die Kühleinrichtung nach demjenigen von Anspruch 4 erreicht.

In den abhängigen Ansprüchen sind besondere Ausführungsarten der Erfindung angegeben.

Die Erfindung wird anschliessend beispielsweise anhand einer Zeichnung erläutert.

Es zeigen in rein schematischer Darstellung:
- Fig. 1: einen Querschnitt durch ein Target mit eingetragenem Abtragungsprofil und darunter angeordneter Rückplatte mit durch eine flexible Membran abgeschlossenen Kühlkanälen;
- Fig. 2: eine Darstellung analog Fig. 1 mit direkter Kühlung.

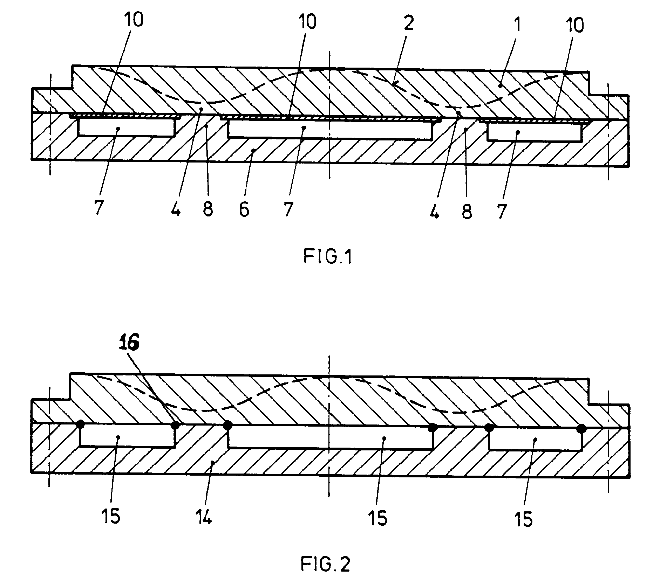

Fig. 1 zeigt den Querschnitt eines Targets 1, in welchen das sich im Betrieb in der Endphase der Ausnützung eines Targets ergebende Erosionsprofil 2 eingezeichnet ist. Im Bereich des grössten Materialabtrags ergeben sich sogenannte Durchbruchzonen 4, in welchen die Gefahr des Wassereinbruchs besteht, wenn z.B. im Störfall das Target vollständig durchzerstäubt wird.

Unter dem Target 1 ist eine Kühlplatte 6 mit Kühlmittelkanälen 7 ersichtlich, welche sich ausserhalb des Bereiches der Durchbruchzonen 4 befinden. Diese Bereiche sind durch Vollmaterialstege 8 der Kühlplatte 6 gestützt und abgedichtet, derart, dass bei einem allfälligen Durchbruch des Targets 1 im Bereich der Durchbruchzonen 4 keine unmittelbare Berührung mit dem Kühlwasser erfolgt. Bei dieser Ausführung sind die Kühlmittelkanäle 7 gegen die Rückseite des Targets 1 hin mit Kanalabschlussmembranen 10 versehen, welche, da sie ausserhalb der möglichen Durchbruchzonen 4 liegen, keiner direkten Zerstäubung ausgesetzt sind. Damit kann ein Durchbruch in das Kühlinittel verhindert werden. Die Kühlkanäle sind, den Erosionsprofilen des Targets 1 entsprechend ausgebildet, z.B. ringförmig.

Das Anbringen der Kühlmittelkanäle 7 ausserhalb der Durchbruchzonen 4 verringert mithin das Risiko, insbesondere bei Störungen einen Durchbruch in das Kühlmedium zu gewärtigen, wobei die durch diese Anordnung möglicherweise etwas geringere Kühlwirkung sich praktisch nicht auswirkt. Der Kühlvorgang kann mittels des Kühlmittels gesteuert werden, also auch instationär sein.

Die Vollmaterialstege 8 verhindern eine übermässige Durchbiegung einer Kanalabschlussmembrane, da sich deren freie Spannweiten infolge der Zwischenstege entsprechend verringern. Ferner versteifen diese Stege 8 die Kühlplatte 6, wobei sie zusätzlich einen Schutz der verletzlichen dünnen Kanalabschlussmembran 10 darstellen.

In Fig. 2 ist ein direktes Kühlen des Targets vorgesehen, wobei eine Kühlplatte 14 mit offenen Kühlmittelkanälen 15 versehen ist. Zum Abdichten dienen, wie ersichtlich, Dichtungsschnüre 16 oder dergleichen. Auch hier sind diese Kanäle ausserhalb der Durchbruchzonen angeordnet, um bei Störfällen das Gefahrenmoment eines Wassereinbruches zumindest zu verringern.

Beim Durchstäuben des Targets bis auf den massiven Teil der Konstruktion auf der Targetrückseite bleibt noch die Möglichkeit, dass das Substrat durch das Konstruktionsmaterial kontaminiert wird. Diese Kontamination steht zwar in keinem Verhältnis zu derjenigen, welche bei einem Kühlmitteleinbruch zu erwarten wäre. Es ist aber wünschenswert, auch kleinste Kontaminationsmöglichkeiten auszuschliessen. Eine Lösung dieses Problems wird erreicht durch Verwendung von prozesstolerantem Konstruktionsmaterial im Bereich des zu erwartenden Targetdurchbruches sowie durch rechtzeitiges Abschalten des Prozesses.

Prozesstolerantes Konstruktionsmaterial ist ein Material, welches die Schichtqualität bei Kontamination nicht unzulässig beeinträchtigt. Dies ist somit eine Frage der sorgfältigen Materialwahl für den beim Targetdurchbruch exponierten Bereich der Konstruktion. In vielen Fällen genügt auch eine Beschichtung dieses exponierten Bereiches, wodurch grössere Freiheitsgrade in der Wahl des Materials für die mechanische Konstruktion sowie kostengünstigere Lösungen ermöglicht werden.

In der Halbleiterindustrie werden zur Beschichtung von Siliziumwafer beispielsweise oft Metallegierungen aus Aluminium mit wenigen Prozentanteilen Silizium und Kupfer verwendet. Das zu verwendende Target besteht dann aus dieser Legierung mit sehr hoher Reinheit. Eine gute Wahl für das Konstruktionsmaterial im zu erwartenden Targetdurchbruchbereich ist in diesem Falle Kupfer mit hoher Reinheit. Dieses Material erlaubt eine günstige Signalauswertung, ohne den Prozess negativ zu beeinflussen, da Kupfer funktionaler Bestandteil der Schicht ist. Zur Signalauswertung können optische und/oder elektrische Grössen verwendet werden. Als optische Grösse kann die Farbe der Plasmaentladung überwacht werden. Im angegebenen Beispiel hat das Plasma über dem Target aus vorerwähnter Legierung mit dominantem Aluminiumanteil, wenn noch kein Targetdurchbruch vorliegt, eine blaue Farbe. Tritt nun ein Durchbruch auf, so wird etwas Kupfer der Konstruktion freigelegt und durch das Plasma aktiviert. Dies hat zur Folge, dass die Farbe der Plasmaentladung von blau zu grün umschlägt. Dieser Farbumschlag ist nun leicht mit bekannten Methoden der Optoelektronik zu erfassen. Das resultierende Signal kann verwendet werden, um weitere Aktivitäten auszulösen, wie beispielsweise den Prozess abzuschalten, um einen Targetwechsel vornehmen zu können.

Eine weitere Möglichkeit der Signalerfassung besteht darin, die beim Durchbruch ändernden elektrischen Entladungsbedingungen auszuwerten. Dies kann durch einfaches Messen von Veränderungen in der Stromspannungs-Charakteristik erfolgen. Dies ist möglich, weil die Entladungsspannung materialabhängig ist. Eine Magnetronentladung mit einem Target aus vorerwähnter Legierung bei einer Betriebsleistung von 10kW arbeitet beispielsweise mit einer Entladungsspannung von 550 Volt. Bei einem Targetdurchbruch wird das Kupfer die Plasmaentladung beeinflussen und die Entladungsspannung auf ca. 500 Volt senken. Dieser Vorgang kann leicht erfasst und, wie beim optischen Verfahren bereits erwähnt, ausgewertet werden.

Im Sinne der vorliegenden Ausführungen kann daher beispielsweise die gesamte Breite der beiden Vollmaterialstege 8 einen Fünftel der Gesamtbreite des Targets 1 betragen. Dieser Wert kann aber auch unterschritten werden, sollte jedoch nicht weniger als ca. 10% betragen. Diese Grenzwerte entsprechen den ungekühlten Flächen des Targets in den Bereichen der stärksten Erosion.

Die geschilderten Konstruktionen vermindern die Gefahr des Wassereinbruches ins Vakuum beim Durchzerstäuben eines Targets im Falle einer Störung. Mögliche Kühlmitteleinbrüche beim Durcherodieren des Targets werden vermieden und dadurch die Betriebssicherheit der Einrichtung bei gleichzeitiger Erhöhung der Leistungsfähigkeit drastisch verbessert.

Die vorliegende Erfindung löst mithin das Problem eines unzulässigen Kühlmitteleinbruchs und erhöht die Zuverlässigkeit des Betriebsverhaltens ganz wesentlich.

## Patentansprüche

1. Verfahren zum Kühlen von Targets (1) in Zerstäubungsquellen, bei welchem man das Kühlmedium direkt oder über eine folienartige Wand (10) auf die Targetrückseite einwirken lässt, dadurch gekennzeichnet, dass man die Targetrückseite ausschliesslich in Bereichen direkt oder über die folienartige Wand (10) mit dem Kühlmedium kontaktiert, die nicht als erste durcherodiert werden.

2. Verfahren nach Anspruch 1, dadurch gekennzeichnet, dass man instationär kühlt.

3. Verfahren nach einem der Ansprüche 1 oder 2, dadurch gekennzeichnet, dass man die von der Durcherosion zuerst gefährdeten Rückseitenbereiche (4) des Targets (1) mittels Stegen (8) stützt.

4. Kühleinrichtung für Targets von Zerstäubungsquellen mit einem Target (1) und mit einer von Kühlmittel durchflossenen Kanalanordnung (7), die gegen die Targetrückseite offen oder mittels einer folienartigen Wand verschlossen ist, dadurch gekennzeichnet, dass die Kanalanordnung durch Kanäle (7) gebildet ist, die ausserhalb der Bereiche (4) der stärksten Erosion des Targets (1) verlaufen.

5. Kühleinrichtung nach Anspruch 4, dadurch gekennzeichnet, dass die Kühlkanäle (7) mindestens auf der der Targetrückseite zugekehrten Seite je eine folienartige Abschlusswand (10) aufweisen.

6. Kühleinrichtung nach einem der Ansprüche 4 oder 5, dadurch gekennzeichnet, dass die Kühlkanäle (7) in einer Kühlplatte (6) verlaufen und durch Stege (8) voneinander getrennt sind, wobei Stege (8) im Bereich der stärksten Erosion (4) des Targets (1) verlaufen, um diese Bereiche (4) mechanisch zu stützen.

7. Kühleinrichtung nach einem der Ansprüche 4 bis 6, dadurch gekennzeichnet, dass die Kanäle (7) gegen die Targetrückseite hin offen und an den Auflageflächen der Stege (8) am Target kühlmitteldicht getrennt sind.

8. Kühleinrichtung nach einem der Ansprüche 4 bis 7, dadurch gekennzeichnet, dass die Kanaloberfläche mindestens 80% der Targetrückfläche, aber höchstens 90% beträgt.

9. Kühleinrichtung nach Anspruch 6, dadurch gekennzeichnet, dass die Stege aus einem Material hergestellt oder mit einem Material beschichtet sind, welches beim Durcherodieren des Targets die Entladungs-Charakteristik des Plasmas so ändert, dass die resultierenden optischen und elektrischen Signaländerungen zur Erfassung dieses Betriebszustandes verwendbar sind und dass das Material so ausgewählt wird, dass der Prozess nicht störend kontaminiert wird.

## Claims

1. Process for cooling targets (1) in sputtering sources, in which the coolant acts directly or via a sheet-like wall (10) on the target rear, characterized in that the target rear makes contact with the coolant directly or via the sheet-like wall (10) exclusively in areas which are not the first to be eroded through.

2. Process according to Claim 1, characterized in that the cooling is carried out non-stationary.

3. Process according to one of Claims 1 or 2, characterized in that the rear areas (4) of the target (1) likely to be first to be eroded through are supported by means of webs (8).

4. Cooling device for targets of sputtering sources with a target (1) and a channel arrangement (7) through which flows coolant, the said channel arrangement being open to the target rear or closed by means of a sheet-like wall, characterized in that the channel arrangement consists of channels (7) which run outside the area (4) of greatest erosion of the target (1).

5. Cooling device according to Claim 4, characterized in that the cooling channels (7) each have a sheet-like closing wall (10) at least on the side facing the target rear.

6. Cooling device according to one of Claims 4 or 5, characterized in that the cooling channels (7) run in a cooling plate (6) and are separated by webs (8), where webs (8) run in the area of greatest erosion (4) of the target (1) in order to support these areas (4) mechanically.

7. Cooling device according to any of Claims 4 to 6, characterized in that the channels (7) are open against the rear of the target and are separated coolant-tight at the support surfaces of the webs (8) on the target.

8. Cooling device according to any of Claims 4 to 7, characterized in that the channel surface amounts to at least 80% but at most 90% of the target rear area.

9. Cooling device according to claim 6, characterized in that the webs are made of or are coated with a material which modifies the discharge characteristics of the plasma when the target is eroded through such that the resulting optical and electrical signal changes can be used to detect this operating state, and that the material is selected such that the process is not contaminated.

## Revendications

1. Procédé pour le refroidissement de cibles (1) dans des sources de pulvérisation, selon lequel on fait agir l'agent de refroidissement sur le côté arrière de la cible directement ou par l'intermédiaire d'une paroi en forme de feuille (10), caractérisé en ce qu'on met le côté arrière de la cible en contact avec l'agent de refroidissement directement ou par l'intermédiaire de la paroi en forme de feuille (10) exclusivement dans des zones qui ne sont pas érodées sur toute l'épaisseur en premier.

2. Procédé selon la revendication 1, caractérisé en ce qu'on procède à un refroidissement non stationnaire.

3. Procédé selon l'une des revendications 1 ou 2, caractérisé en ce qu'on soutient à l'aide de nervures (8) les zones (4) du côté arrière de la cible (1) qui sont menacées en premier par l'érosion sur toute l'épaisseur.

4. Dispositif de refroidissement pour des cibles de sources de pulvérisation comportant une cible (1) et un dispositif de canaux (7) qui est traversé par un agent de refroidissement et qui est ouvert en direction du côté arrière de la cible, ou fermé à l'aide d'une paroi en forme de feuille, caractérisé en ce que le dispositif de canaux est formé par des canaux (7) qui s'étendent à l'extérieur des zones (4) d'érosion maximum de la cible (1).

5. Dispositif de refroidissement selon la revendication 4, caractérisé en ce que les canaux de refroidissement (7) comportent chacun, au moins sur le côté tourné vers le côté arrière de la cible, une paroi de fermeture en forme de feuille (10).

6. Dispositif de refroidissement selon l'une des revendications 4 ou 5, caractérisé en ce que les canaux de refroidissement (7) s'étendent dans une plaque de refroidissement (6) et sont séparés les uns des autres par des nervures (8), ces nervures (8) s'étendant dans la zone d'érosion maximum (4) de la cible (1) afin de soutenir mécaniquement ces zones (4).

7. Dispositif de refroidissement selon l'une des revendications 4 à 6, caractérisé en ce que les canaux (7) sont ouverts en direction du côté arrière de la cible et sont séparés de façon étanche à l'agent de refroidissement au niveau des surfaces d'appui des nervures (8) contre la cible.

8. Dispositif de refroidissement selon l'une des revendications 4 à 7, caractérisé en ce que la surface des canaux représente au moins 80 % de la surface arrière de la cible, mais au maximum 90 %.

9. Dispositif de refroidissement selon la revendication 6, caractérisé en ce que les nervures sont réalisées ou revêtues à l'aide d'un matériau qui, lors d'une érosion de la cible sur toute l'épaisseur, modifie la courbe caractéristique de décharge du plasma de telle sorte que les variations de signaux optiques et électriques résultantes sont utilisables pour la détection de cet état de marche, et en ce que le matériau est choisi pour ne pas contaminer de façon gênante le processus.
